# EUROPEAN PATENT SPECIFICATION

(11) **EP 1 482 570 B1**
(45) Date of publication and mention of the grant of the patent: **26.04.2006**
(21) Application number: 03012439.0
(22) Date of filing: 30.05.2003
(51) Int. Cl.: H01L 41/053, F02M 61/16

(54) **Thermally compensated piezoelectric assembly**
Thermisch kompensierter piezoelektrischer Aufbau
Ensemble piézo-électrique compensé thermiquement

(43) Date of publication of application: 01.12.2004
(73) Proprietor: Siemens VDO Automotive S.p.A., 56040 Fauglia (Pisa) (IT)
(72) Inventor: Mariani, Giuseppe, 57128 Livorno (IT); Zanoboni, Cristiano, 57016 Rosignano Solvay (LI) (IT)
(74) Representative: Berg, Peter

(56) References cited:
- WO-A-02/38948
- DE-A- 19 947 779
- US-A- 4 584 980
- US-A- 5 810 255

## Description

The present invention refers to a piezoelectric assembly, comprising a piezoelectric element being capable of an electrically induced mechanical expansion in one dimension when supplied with a suitable electrical voltage, which piezoelectric element is situated between a limiting element and a piston element, which piston element is, by the electrically induced expansion of the piezoelectric element, movable relative to the limiting element; and further comprising a thermal compensation means compensating for relative changes in position between the piston element and the limiting element due to a thermally induced expansion of the piezoelectric element by means of an elastic element mechanically buffering thermally induced expansions of the piezoelectric element.

Actuator units comprising a piezoelectric element are commonly used in modern motor vehicles for controlling the injection of fuel to the vehicle's engine. By means of such an actuator a valve assembly can be operated fast and with high precision.

Piezoelectric elements commonly used in piezoelectric assemblies are known to expand in at least one direction when an electrical voltage is applied to the elements. The direction and the extent of such expansion is depending on the crystal structure of the piezoelectric elements, the direction of the voltage applied across the elements and the magnitude of the voltage. In common injector assemblies, where the expansion of the piezoelectric elements is used to move a piston element to operate an acting unit, e.g. a valve assembly, the piezoelectric elements and the electrodes used to apply the voltage are usually configured such, that the expansion is mainly parallel to the longitudinal axis of the assembly, i.e. parallel to the movement of the piston element.

The piezoelectric elements, that are commonly used, are made from some quartz ceramics having a relatively large thermal expansion coefficient. That is, due to thermal changes the relative position of the piston element to the limiting element and, thus, to the acting unit and/or the force applied to the acting unit by the piston element may change depending on the temperature, thus causing temperature dependent differences in the fuel volume injected to the engine. Keeping in mind the large changes in temperature a vehicle's engine may be submitted to, this is a not tolerable disadvantage.

To compensate for the thermally induced expansion of the piezoelectric element it is known to use thermal compensation means. The problem with temperature compensation is, that thermally induced expansion and electrically induced expansion of the piezoelectric element yield the same effect, namely a change in the longitudinal dimension of the piezoelectric element. However, only one kind of expansion, namely the thermally induced one, has to be compensated, while the other one is needed to actuate the acting unit.

DE 199 48 359 A1 discloses a double wall housing of a piezoelectric actuator assembly comprising a ceramic tube around the piezoelectric element, which tube has a thermal expansion coefficient, which is essentially the same as the piezoelectric element's one. On one side the tube has got a cap acting as an abutment element for the electrically induced expansion, i.e. for the actuating movement of the piston element. This inner housing is contained within an outer case of thermally rigid material and the inner housing is biased against the outer case by a strong Belleville spring. Thus, the thermal expansion of the piezoelectric element together with the inner housing is buffered by the Belleville spring, while the Belleville spring is strong enough to abut the inner housing during electrically induced expansions of the piezoelectric element.

A severe disadvantage of this device according to the state of the art is the important role that is played by the proper choice of strength of the Belleville spring, which has to be weak enough to allow thermal expansion of the piezoelectric element and the inner housing, while being strong enough to prevent a compensation of the electrically induced expansion. Even an initially proper choice cannot count for variations due to aging etc. Also the inner housing and the piezoelectric element have to be well adapted to each other in terms of their thermal expansion coefficients. Suitable materials are very expensive and often show disadvantageous properties like brittleness or softness.

US 5,810,255 A discloses a clamping device for a piezoelectric actuator of a fuel injection valve. The clamping device is configured as a clamping ring that is arranged coaxial to a piezoelectric stack that axially moves a valve member to open or close the valve. When an operating voltage is applied to the clamping ring, the clamping ring reduces its inner diameter and blocks the piezoelectric stack in its axial position. When the operating voltage is not applied to the clamping ring the piezoelectric stack can move in axial direction within the clamping ring.

It is an object of the present invention to provide a piezoelectric assembly which overcomes the disadvantages of the prior art and in particular to provide a device featuring more exact integrated thermal compensation substantially independent from material parameters.

This object is obtained by the features of the independent claim. Preferred embodiments of the present invention are defined by the depending claims.

The piezoelectric assembly according to the present invention has a mechanical isolation means for mechanically isolating the elastic element during electrically induced expansions of the piezoelectric element. This means that the elastic element can be optimised with respect to its task as a buffer for the thermally induced expansion, because it is not submitted to any force due to the electrically induced expansion of the piezoelectric element. This is the effect of the mechanical isolation.

It is advantageous to couple the elastic element being coupled to the piezoelectric element by a rigid coupling element, and to configure the mechanical isolation means to block, when actuated, a compensating movement of said coupling element. It is the effect of such an implementation that the mechanical isolation of the elastic element can be carried out by simple mechanical measures. A moving rigid element offers easy application points for blocking means, in contrast to an elastic element or the piezoelectric element. When no electrical voltage is supplied to the piezoelectric element the thermally induced expansion of the piezoelectric element is translated into a compensating movement of the rigid coupling means and buffered by the elastic element, which is deformed accordingly. When the compensating movement of the rigid coupling element is prevented by the isolation means, it is fixed in a position according to the current temperature and serves as an abutment for the electrically induced expansion of the piezoelectric element.

In the present invention the isolation means is comprising a locking element, which locking element is movable between a locking position preventing a compensating movement of the rigid coupling element and an enabling position allowing for a compensating movement of the rigid coupling element. This improvement features the advantage that the blocking of the rigid coupling element is easily carried out using a preferably small additional locking element, which interacts with a corresponding structure of the rigid coupling element. Though an additional part is needed, the device in total is advantageous, because of the easiness of moving a small part, in particular when using a magnetic force.

In a preferred embodiment of the piezoelectric assembly according to the present invention the mechanical isolation means are configured to be actuated electro-magnetically. A major advantage of such an embodiment is that an electro-magnetic actuation of the mechanical isolation means is essentially temperature independent, robust, fast and almost wear-free. Also, as quite a high power control voltage is necessary to actuate the piezoelectric element in any case, it is easy to extend the power supply such that an electro-magnetic actuation device is supplied simultaneously.

In a further improved embodiment the locking element is configured as a subdivided clamping ring collaring a shaft of the rigid coupling element and clamping the same in the locking position. It is an advantage of such an embodiment that a clamping ring sliding on a shaft of the rigid coupling element provides an easy to install locking element, that can be moved by a magnetic force between its enabling position and its locking position, where the subdivisions are squeezed against the shaft preventing its movement.

In a further improved embodiment of the present invention there are provided at least two subdivisions of the clamping ring each comprising a tapered section and further there is provided a fixed abutment element with a correspondingly tapered opening, in which opening the tapered sections of the clamping ring are squeezed against the shaft of the rigid coupling element in the locking position. It is an advantage of this embodiment that the squeezing of the shaft is automatically carried out, when the correspondingly tapered sections of the clamping ring are driven into the tapered opening of the fixed abutment element.

In a further improved variation the piezoelectric assembly according to the invention is characterized by the fixed abutment element carrying an electro-magnetic coil to electro-magnetically move the clamping ring between the locking position and the enabling position. The major advantage of this embodiment is the double use of the abutment element as such as well as for carrying the electro-magnetic coil.

It is advantageous, if there is provided a second elastic element holding in place the locking element in the enabling position. The major advantage of such an embodiment is that the locking element in its enabling position may always be held in a position closed to its transition into the locking position, thereby accelerating the transition when the electro-magnetic force is applied.

In the following the present invention will be explained in more detail with respect to the drawing, in which

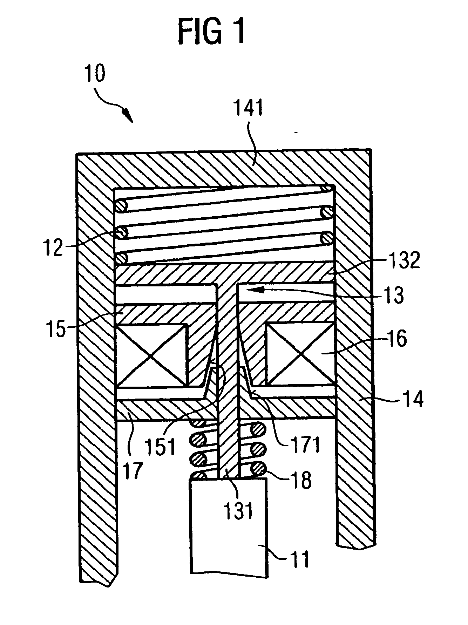

Figure 1 illustrates a preferred embodiment of the present invention.

Fig. 1 illustrates a preferred embodiment of a piezoelectric assembly 10 according to the present invention. The functional heart of the assembly 10 is the piezoelectric element 11, which is shown in part only. Not shown in Fig. 1 is the piston element, which is to be moved by the electrically induced expansion of the piezoelectric element 11 in order to actuate some acting unit, e.g. a valve assembly.

The piezoelectric element 11 is mechanically coupled to a spring 12 by a rigid coupling element 13 comprising a shaft 131 and a resting plate 132. The spring 12 is biased between the resting plate 132 an a fixed cap 141 of a rigid housing 14.

The elements mentioned so far are capable of providing for a thermal compensation of the piezoelectric element 11. The thermally induced expansion of the piezoelectric element 11 is translated into a compensating movement of the rigid coupling element 13 and buffered by the spring 12, which is deformed accordingly. The cap 141 of the housing 14 serves as an abutment element for the spring 12.

However, if no further measures had been taken according to the invention, the electrically induced expansions of the piezoelectric element 11 intended to actuate the acting unit would be compensated accordingly. To prevent this, there is provided a fixed collar 15, which is attached to the housing 14 and features a central hole, through which the shaft 131 may slide. The central hole has tapered faces 151, which are, in the embodiment shown, opened towards the piezoelectric element 11.

The collar 15 is used to carry an electric coil, which can be supplied with an electrical current in order to exhibit a magnetic force. Due to this magnetic force, a clamping ring 17 will be attracted towards the collar 15.

The clamping ring 17 consists of a plurality of subdivisions, preferably four, surrounding the shaft 131. Each subdivision is provided with a tapered section 171 at its inner end. In the enabling position of the clamping ring 17, i.e. when the clamping ring 17 is not attracted by the magnetic force of the coil 16, the shaft 131 may slide through the opening in between the tapered sections 171 of the clamping ring 17. In the locking position, i.e. when the clamping ring 17 is attracted by the magnetic force of the coil 16, the tapered sections 171 of the clamping ring 17 slide in between the tapered faces 151 of the fixed collar 15. Thus, the subdivisions of the clamping ring 17 are led together exhibiting a squeezing force to the shaft preventing its movement and, thus, the compensation of the electrically induced expansion of the piezoelectric element 11.

In the preferred embodiment there is a spring 18 provided in-between the piezoelectric element 11 and the clamping ring 17. The spring 18 is used to hold the tapered sections 171 of the clamping ring 17, when in the enabling position, in a light contact to the shaft 131 in order to minimize the transition movement of the clamping ring 17 from the enabling position to the locking position.

For an effective application of the present invention it is preferred, that the coil 16 and the piezoelectric element 11 are supplied with electric energy simultaneously. Thus the coupling element 13 is locked whenever the piezoelectric element acts as an actuator. However, its thermal compensation movement is enabled at any other time, particularly between every two actuating cycles of the piezoelectric element 11, which may occur at a rather high frequency.

While the invention has been described in the context of a preferred embodiment, it will be apparent to those skilled in the art that the present invention may be modified in numerous ways and may assume many embodiments other than that specifically set out and described above.

## Claims

1. A piezoelectric assembly, comprising
- a piezoelectric element (11) being capable of an electrically induced mechanical expansion in one dimension when supplied with a suitable electrical voltage, which piezoelectric element (11) is situated between a limiting element (141) and a piston element, which piston element is, by the electrically induced expansion of the piezoelectric element, movable relative to the limiting element (141);
- a thermal compensation means compensating for relative changes in position between the piston element and the limiting element (141) due to a thermally induced expansion of the piezoelectric element (11) by means of an elastic element (12) mechanically buffering thermally induced expansions of the piezoelectric element (11), the elastic element (12) being coupled to the piezoelectric element (11) by a rigid coupling element (13);
- a mechanical isolation means (15, 16, 17) for mechanically isolating the elastic element (12) during electrically induced expansions of the piezoelectric element (11) and to block, when actuated, a compensating movement of said coupling element (13),
**characterised in that**
the isolation means comprises a locking element (17), which is movable in axial direction between a locking position preventing a compensating movement of the rigid coupling element (13) and an enabling position allowing for a compensating movement of the rigid coupling element (13).

2. The piezoelectric assembly according to claim 1,
**characterised in that**
the mechanical isolation means (15, 16, 17) being configured to be actuated electro-magnetically.

3. The piezoelectric assembly according to claim 1 or 2,
**characterised in that**
the locking element being configured as a subdivided clamping ring (17) collaring a shaft (131) of the rigid coupling element (13) and clamping the same in the locking position.

4. The piezoelectric assembly according to claim 3,
**characterised by**
at least two subdivisions of the clamping ring (17) each comprising a tapered section (171) and by a fixed abutment element (15) with a correspondingly tapered opening (151), in which opening the tapered sections (171) of the clamping ring (17) are squeezed against the shaft (131) of the rigid coupling element (13) in the locking position.

5. The piezoelectric assembly according to claim 4,
**characterised in that**
the fixed abutment element (15) carrying an electro-magnetic coil (16) to electro-magnetically move the clamping ring (17) between the locking position and the enabling position.

6. The piezoelectric assembly according to one of the claims 1 to 4,
**characterised by**
a second elastic element (18) holding in place the locking element (17) in the enabling position.

## Revendications

1. Ensemble piézo-électrique, comprenant
- un élément piézo-électrique (11) capable d'une dilatation mécanique produite électriquement dans une dimension quand il est alimenté avec une tension électrique appropriée, lequel élément piézo-électrique (11) est situé entre un élément limiteur (141) et un élément de piston, lequel élément de piston est, par la dilatation produite électriquement de l'élément piézo-électrique, mobile par rapport à l'élément limiteur (141) ;
- un moyen de compensation thermique pour compenser des variations relatives de position entre l'élément de piston et l'élément limiteur (141) dues à une dilatation produite thermiquement de l'élément piézo-électrique (11) au moyen d'un élément élastique (12) amortissant mécaniquement des dilatations produites thermiquement de l'élément piézo-électrique (11) par un élément de couplage rigide (13) ;
- un moyen d'isolation mécanique (15, 16, 17) pour isoler mécaniquement l'élément élastique (12) lors des dilatations produites électriquement de l'élément piézo-électrique (11) et pour bloquer, quand il est actionné, un mouvement de compensation dudit élément de couplage (13),
**caractérisé en ce que**
le moyen d'isolation comprend un élément de blocage (17), qui est mobile en direction axiale entre une position de blocage empêchant un mouvement de compensation de l'élément de couplage rigide (13) et une position opérationnelle permettant un mouvement de compensation de l'élément de couplage rigide (13).

2. Ensemble piézo-électrique selon la revendication 1, **caractérisé en ce que** le moyen d'isolation mécanique (15, 16, 17) est configuré pour être actionné de manière électromagnétique.

3. Ensemble piézo-électrique selon la revendication 1 ou 2, **caractérisé en ce que** l'élément de blocage est configuré comme un anneau de serrage subdivisé (17) encerclant un arbre (131) de l'élément de couplage rigide (13) et serrant celui-ci dans la position de blocage.

4. Ensemble piézo-électrique selon la revendication 3, **caractérisé par** au moins deux subdivisions de l'anneau de serrage (17) comprenant chacune une section conique (171) et par un élément de butée fixe (15) avec une ouverture conique correspondante (151), ouverture dans laquelle les sections coniques (171) de l'anneau de serrage (17) sont pressées contre l'arbre (131) de l'élément de couplage rigide (13) dans la position de blocage.

5. Ensemble piézo-électrique selon la revendication 4, **caractérisé en ce que** l'élément de butée fixe (15) supporte une bobine électromagnétique (16) pour déplacer de manière électromagnétique l'anneau de serrage (17) entre la position de blocage et la position opérationnelle.

6. Ensemble piézo-électrique selon l'une des revendications 1 à 4, **caractérisé par** un deuxième élément élastique (18) maintenant en place l'élément de blocage (17) dans la position opérationnelle.

## Patentansprüche

1. Piezoelektrische Einheit mit
- einem piezoelektrischen Element (11), das zu einer elektrisch induzierten mechanischen Expansion in einer Dimension in der Lage ist, wenn es mit einer geeigneten elektrischen Spannung beaufschlagt wird, und das zwischen einem Begrenzungselement (141) und einem Kolbenelement angeordnet ist, wobei das Kolbenelement durch die elektrisch induzierte Expansion des piezoelektrischen Elementes relativ zum Begrenzungselement (141) bewegbar ist,
- einer Thermokompensationseinrichtung, die relative Positionsänderungen zwischen dem Kolbenelement und dem Begrenzungselement (141) infolge einer thermisch induzierten Expansion des piezoelektrischen Elementes (11), mit Hilfe eines elastischen Elementes (12), das auf mechanische Weise thermisch induzierte Expansionen des piezoelektrischen Elementes (11) abpuffert, kompensiert, wobei das elastische Element (12) mit dem piezoelektrischen Element (11) über ein starres Kupplungselement (13) verbunden ist,
- einer mechanischen Isolationseinrichtung (15,16,17) zum mechanischen Isolieren des elastischen Elementes (12) während elektrisch induzierter Expansionen des piezoelektrischen Elementes (11) und zum Blockieren, bei Betätigung, einer Kompensationsbewegung des Kupplungselementes (13),
**dadurch gekennzeichnet, daß**
die Isolationseinrichtung ein Blockierelement (17) aufweist, das in axialer Richtung zwischen einer Blockierposition, die eine Kompensationsbewegung des starren Kupplungselementes (13) verhindert, und einer Befähigungsposition, die eine Kompensationsmöglichkeit des starren Kupplungselementes (13) ermöglicht, bewegbar ist.

2. Piezoelektrische Einheit nach Anspruch 1, **dadurch gekennzeichnet, daß** die mechanische Isolationseinrichtung (15,16,17) so ausgebildet ist, daß sie elektromagnetisch betätigt wird.

3. Piezoelektrische Einheit nach Anspruch 1 oder 2, **dadurch gekennzeichnet, daß** das Blockierelement als unterteilter Klemmring (17) ausgebildet ist, der einen Schaft (131) des starren Kupplungselementes (13) kragenförmig umgibt und diesen in der Blockierposition festklemmt.

4. Piezoelektrische Einheit nach Anspruch 3, **gekennzeichnet durch** mindestens zwei Untereinheiten des Klemmringes (17), die jeweils einen sich verjüngenden Abschnitt (171) umfassen, und **durch** ein festes Anschlagelement (15) mit einer sich entsprechend verjüngenden Öffnung (151), in der die sich verjüngenden Abschnitte (171) des Klemmringes (17) gegen den Schaft (131) des starren Kupplungselementes (13) in der Blockierposition gequetscht werden.

5. Piezoelektrische Einheit nach Anspruch 4, **dadurch gekennzeichnet, daß** das feste Anschlagelement (15) eine elektromagnetische Spule (16) trägt, um den Klemmring (17) auf elektromagnetische Weise zwischen der Blockierposition und der Befähigungsposition zu bewegen.

6. Piezoelektrische Einheit nach einem der Ansprüche 1 bis 4, **gekennzeichnet durch** ein zweites elastisches Element (18), das das Blockierelement (17) in der Befähigungsposition an Ort und Stelle hält.
